# EUROPEAN PATENT SPECIFICATION

(11) **EP 3 809 127 B1**
(45) Date of publication and mention of the grant of the patent: **06.03.2024**
(21) Application number: 19819580.2
(22) Date of filing: 12.06.2019
(51) Int. Cl.: G01N 27/30

(54) **SILVER-SILVER CHLORIDE ELECTRODE AND ELECTRICAL CIRCUIT**
SILBER-SILBERCHLORID-ELEKTRODE UND ELEKTRISCHE SCHALTUNG
ÉLECTRODE EN CHLORURE D'ARGENT-ARGENT ET CIRCUIT ÉLECTRIQUE

(30) Priority: 14.06.2018 JP 2018113792
(43) Date of publication of application: 21.04.2021
(73) Proprietor: NOK Corporation, Minato-ku, Tokyo 105-8585 (JP)
(72) Inventor: FUTASHIMA Ryo, Fujisawa-shi, Kanagawa 251-0042 (JP)
(74) Representative: TBK
(86) International application number: PCT/JP2019/023195
(87) International publication number: WO 2019/240147

(56) References cited:
- WO-A1-98/03431
- WO-A1-2017/031487
- WO-A1-2018/003702
- WO-A1-2018/070433
- JP-A- H0 290 052
- JP-A- S5 126 789
- JP-A- 2001 242 115
- JP-A- 2006 275 711
- Anonymous: "Creative Materials Introduces new electrically conductive medical silver/silver-chloride (Ag/AgCl) electrode ink", , 1 February 2016 (2016-02-01), XP055808588, Retrieved from the Internet: URL:http://www.creativematerials.com/news/ pr-medical-electrode-ink-and-coating.php [retrieved on 2021-05-28]
- Creativematerials: "126-49 SILICONE MEDICAL ELECTRODE INK", Creative Materials, Inc., 12 February 2016 (2016-02-12), XP055808653, Retrieved from the Internet: URL:https://server.creativematerials.com/d atasheets/DS_126_49.pdf [retrieved on 2021-05-28]
- SAFARI S. ET AL: "Microfluidic Reference Electrode with Free-Diffusion Liquid Junction", JOURNAL OF THE ELECTROCHEMICAL SOCIETY, vol. 160, no. 10, 1 January 2013 (2013-01-01), pages B177-B183, XP055808668, ISSN: 0013-4651, DOI: 10.1149/2.007310jes
- Anonymous: "Phosphate-buffered saline - Wikipedia, the free encyclopedia", , 18 February 2016 (2016-02-18), XP055263772, Retrieved from the Internet: URL:https://en.wikipedia.org/wiki/Phosphat e-buffered_saline#cite_note-1 [retrieved on 2016-04-08]

## Description

### TECHNICAL FIELD

The present invention relates to silver-silver chloride electrodes and to electric circuits.

### BACKGROUND ART

Silver-silver chloride electrodes are widely used as measurement electrodes and reference electrodes for measuring minute currents in electrochemistry and electrophysiology because they are nonpolarizable, have a stable potential, and have a high charge transfer reaction rate.

As a method for producing a silver-silver chloride electrode, a method is known in which silver chloride is formed by electrolysis on a surface of a silver plate or silver wire immersed in a chloride solution.

Furthermore, a method for producing a silver-silver chloride electrode composed of silver, silver chloride, and a heat-resistant resin are formed on a substrate is known in which a conductive paste obtained by dispersing silver powder, silver chloride powder, and polyimide (binder) in an organic solvent is applied on the substrate and heated (Patent Document 1). Furthermore, Patent Document 2 discloses a method in which a paste in which silver particles are dispersed in a resin material is applied to a substrate to form an electrode, and then the electrode is treated with hypochlorous acid to make a surface of the electrode silver chloride. Patent Document 3 provides plated particles for use in silver/silver chloride ink for making medical devices. Patent Document 4 provides a silver chloride paste that comprises a binder resin and a silver chloride support in which sliver chloride is supported on a carrier. Patent Document 5 discloses particles that include cores (for example, silver or nickel cores) having silver chloride substantially about the external surfaces thereof, each of the cores constituting at least 5 %, by weight, of each of the particles and being composed of a material other than silver chloride. Non-Patent Document 1 discloses a new electrically conductive medical silver/silver-chloride electrode ink and coating. Non-Patent Document 2 provides a flexible, electrically conductive, silicone-based ink.

### BACKGROUND DOCUMENTS

### Patent Documents

Patent Document 1: JP-A-05-142189
Patent Document 2: JP-A-2005-292022
Patent Document 3: WO 2017/031487 A1
Patent Document 4: WO 2018/003702 A1
Patent Document 5: WO 98/03431 A1
Non-Patent Document 1: Anonymous: "Creative Materials, Inc., has introduced a new electrically conductive medical silver/silver-chloride electrode ink and coating"
Non-Patent Document 2: Creative Materials: "126-49 SILICONE MEDICAL ELECTRODE INK"

### SUMMARY OF THE INVENTION

In recent years, studies using microfluidic devices has progressed in electrochemistry and electrophysiology. For example, it is conceivable to use silver-silver chloride electrodes to measure the microcurrent of fluid in a microfluidic device. In this case, a silver-silver chloride electrode that has high adhesion to silicone rubber, which is a material for a plate used in a microfluidic device, and that can stably maintain high conductivity, is desired.

Accordingly, the present invention provides a silver-silver chloride electrode having high adhesion to silicone rubber and capable of stably maintaining high conductivity, and provides an electric circuit having two silver-silver chloride electrodes.

A silver-silver chloride electrode according to an aspect of the present invention as defined in claim 1 is a silver-silver chloride electrode including silver powder, silver chloride powder, hydrophilic silica powder, and silicone rubber as a binder in which silver powder, silver chloride powder and hydrophilic silica powder are dispersed. The silver-silver electrode contains a large amount of chloride and sodium ions by being treated by immersion in a 10 wt% sodium chloride aqueous solution such that the current density of the current flowing through an electric circuit is equal to or greater than 7.61 µA/mm² after 5 minutes from the beginning of application of voltage to the electric circuit when the electric circuit in which two silver-silver chloride electrodes and a phosphate buffered saline are connected in series is made up of the two silver-silver chloride electrodes and the phosphate buffered saline containing no calcium and no magnesium interposed between the two silver-silver chloride electrodes, wherein the voltage is 0.3 Volts.

In this aspect, it is possible to provide a silver-silver chloride electrode that has high adhesion to silicone rubber and can stably maintain high conductivity.

An electric circuit according to an aspect of the present invention as defined in claim 2 is an electric circuit including two silver-silver chloride electrodes and a phosphate buffered saline not containing calcium or magnesium interposed between the two silver-silver chloride electrodes, the two silver-silver chloride electrodes and the phosphate buffered saline being connected in series. Each silver-silver chloride electrode includes silver powder, silver chloride powder, hydrophilic silica powder, and silicone rubber as a binder in which silver powder, silver chloride powder and hydrophilic silica powder are dispersed. The silver-silver electrode contains a large amount of chloride and sodium ions by being treated by immersion in a 10 wt% sodium chloride aqueous solution such that the current density of the current flowing through the electric circuit is equal to or greater than 7.61 µA/mm² after 5 minutes from the beginning of application of voltage to the electric circuit, wherein the voltage is 0.3 Volts.

Preferably, the two silver-silver chloride electrodes are formed on a substrate made of silicone rubber.

### BRIEF DESCRIPTION OF THE DRAWINGS

Fig. 1 is a plan view showing silver-silver chloride electrodes manufactured on a substrate;
Fig. 2 is a table showing materials of multiple samples of silver-silver chloride electrodes, wherein samples 4 and 5 are according to the present invention;
Fig. 3 is a schematic diagram showing an experimental apparatus for testing the conductivities of the samples;
Fig. 4 is a graph showing the test results of the conductivities of the samples;
Fig. 5 is a graph showing the test results of the conductivities of the samples; and
Fig. 6 is a table showing the test results of the conductivities of the samples.

### DESCRIPTION OF EMBODIMENT

Hereinafter, an embodiment according to the present invention will be described.

### OUTLINE OF EMBODIMENT

A silver-silver chloride electrode according to the embodiment contains silver powder, silver chloride powder, silica powder, and silicone rubber as a binder in which silver powder, silver chloride powder and silica powder are dispersed. In the embodiment, when an electric circuit in which two silver-silver chloride electrodes and a phosphate buffered saline are connected in series is made up of the two silver-silver chloride electrodes and the phosphate buffered saline containing no calcium and no magnesium interposed between the two silver-silver chloride electrodes, the current density of the current flowing through the electric circuit is equal to or greater than 7.61 µA/mm² after 5 minutes from the beginning of voltage application to the electric circuit.

A method for manufacturing a silver-silver chloride electrode according to the embodiment (the method does not form part of the present invention) includes: a step of producing a paste by mixing silver powder, silver chloride powder, a dispersant, and fumed silica powder with a liquid silicone rubber binder; a step of coating the paste on a substrate made of silicone rubber; and a step of curing the paste on the substrate to form an electrode in which silver, silver chloride, and silica powder are dispersed.

The manufacturing method includes a step of immersing the formed electrode in a sodium chloride aqueous solution.

The step of producing a paste includes a step of producing a mixture of fumed silica powder and silver chloride powder by, first, adding fumed silica to silver chloride, pulverizing and mixing the silver chloride and the fumed silica, and a step of adding the mixture, silver powder, and a dispersant to an RTV (Room Temperature Vulcanizing) silicone rubber.

Fumed silica powder functions as an aggregation inhibitor for silver chloride powder. When fumed silica is not used, silver chloride powder agglomerates. The fumed silica powder is a hydrophilic fumed silica powder.

The dispersant disperses silver powder and silver chloride powder as uniformly as possible in a liquid silicone rubber binder. The dispersant is preferably a polyether-modified silicone surfactant having a polyether chain and a silicone chain, and/or a polyglycerin-modified silicone surfactant having a polyglycerin chain and a silicone chain.

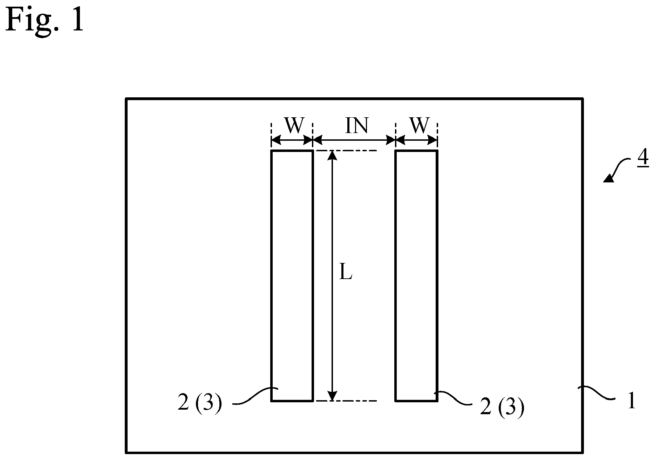

In the step of coating the substrate with the paste, as shown in Fig. 1, a surface of the substrate 1 made of silicone rubber is coated with the paste 2 by a technique such as screen printing or ink jet printing. Curing of the paste 2 results in silver-silver chloride electrodes 3 in which silver, silver chloride, and silica powder are dispersed. In other words, a plate 4 having the silver-silver chloride electrodes 3 provided on a surface is manufactured.

The silver-silver chloride electrodes 3 are produced by immersing the silver-silver chloride electrodes in a sodium chloride aqueous solution and drying them.

In the illustrated embodiment, two silver-silver chloride electrodes 3 are formed on one surface of the substrate 1. However, one or three or more silver-silver chloride electrodes 3 may be formed on the substrate 1, or one or more silver-silver chloride electrodes 3 may be formed on both surfaces of the substrate 1.

In accordance with the silver-silver chloride electrode produced by this production method, in a case in which hydrophilic fumed silica powder is used, it is assumed that the affinity between the surfaces of silver chloride particles and electrolytes (for example, electrolytes in a solution to be measured) is improved since the surface of each silver chloride particle is coated with hydrophilic fumed silica. Although the conductivity of silver chloride itself is low, it is considered that the conductivity is improved by coating silver chloride particles with hydrophilic fumed silica. In addition, it is assumed that since the dispersant disperses silver powder and silver chloride powder, which are conductors, in silicone rubber, which is the binder, the conductor particles within the silver-silver chloride electrode are electrically connected to one other well, so that conductivity is also improved.

Furthermore, the silicone rubber contained in the silver-silver chloride electrode contains chloride ions and sodium ions derived from sodium chloride if the step of immersing in a sodium chloride aqueous solution is conducted. Therefore, it is assumed that the conductivity is improved by ions in addition to the electrical connection of the conductor particles, so that a higher conductivity can be stably maintained.

In addition, by using silicone rubber as a binder, the produced silver-silver chloride electrode 3 has high adhesion to the silicone rubber and does not easily peel off or drop off from the substrate 1. Furthermore, since the silicone rubber contained in the silver-silver chloride electrode contains chloride ions and sodium ions derived from sodium chloride, it is expected to improve durability against external forces caused by, e.g., bending of the silver-silver chloride electrode.

### PRODUCTION EXAMPLES

The inventor manufactured multiple samples each having silver-silver chloride electrodes by the manufacturing method, and tested the conductivities of these samples. For comparison, a sample (Sample 10) having silver electrodes was produced, and the conductivity of the sample was also tested.

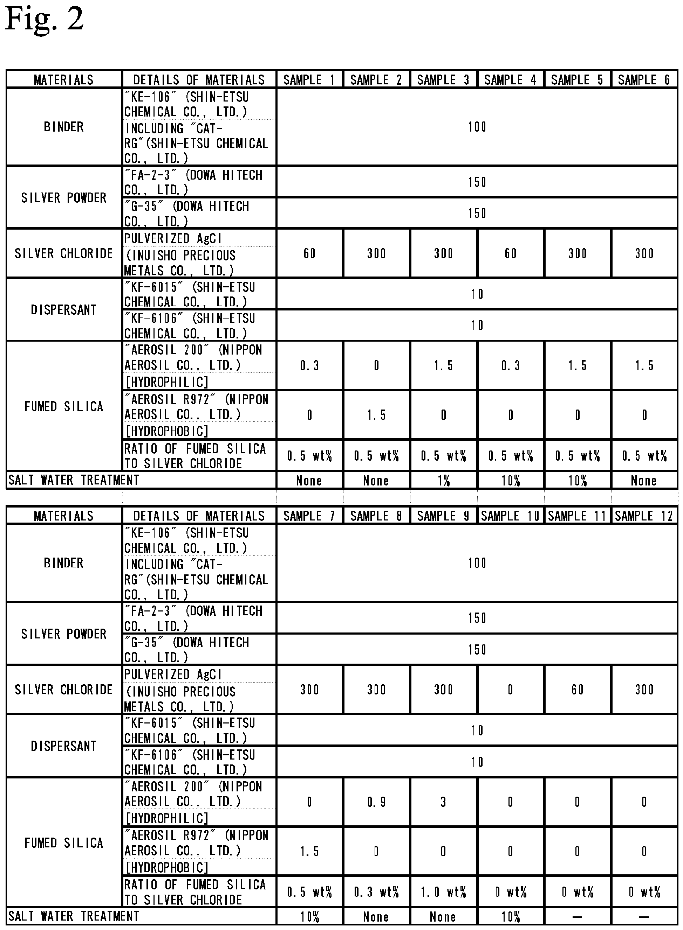

Fig. 2 shows the materials of these samples and details of immersion in a sodium chloride aqueous solution (salt water treatment). Samples 4 and 5 are according to the present invention, whereas samples 1-3 and samples 6-10 are comparative examples.

In Fig. 2, unless otherwise noted, the numerical values represent parts by weight. The "%" in the last line (salt water treatment) indicates the concentration of sodium chloride in the sodium chloride aqueous solution as a percentage, whereas "None" in the last line indicates that the electrodes were intentionally manufactured without performing the salt water treatment. The "-" in the last line indicates that the salt water treatment was abandoned, and that the conductivity test was not performed.

For Samples 1-9, in the step of producing a mixture of fumed silica powder and silver chloride powder, fumed silica was added to silver chloride, and then, silver chloride and fumed silica were pulverized and mixed by means of a centrifugal mill. For Samples 1 to 9, the weight parts of silver chloride and fumed silica in the entire material are as shown in Fig. 2. The raw material silver chloride was produced by Inuisho Precious Metals Co., Ltd., Osaka, Japan. As the fumed silica, there were prepared "AEROSIL^{®} 200 ", which is a hydrophilic fumed silica manufactured by Nippon Aerosil Co., Ltd., Tokyo, Japan, and "AEROSIL^{®} R972" which is a hydrophobic fumed silica manufactured by the same company. "AEROSIL^{®} R972" was used for the manufacture of Samples 2 and 7, whereas "AEROSIL^{®} 200" was used for the manufacture of Samples 1, 3-6, 8, and 9. "AEROSIL^{®}" is a registered trademark. For pulverization and mixing, a centrifugal mill (trade name "ZM 200") manufactured by Retsch Co., Ltd. (currently Verder Scientific Co., Ltd.), Tokyo, Japan was used. Silver chloride and fumed silica were pulverized and mixed, so that the resulting particles passed through a 0.20 mm-mesh screen.

In samples 10 to 12, no fumed silica powder was used. The reason for not using fumed silica powder in Samples 11 and 12 was to confirm the effect of fumed silica powder as an aggregation inhibitor for silver chloride powder. The reason for not using fumed silica powder in Sample 10 was that no silver chloride powder was used, and therefore, fumed silica powder as an aggregation inhibitor was unnecessary.

For silicone rubber as the binder, a mixture of "KE-106", an RTV silicone rubber manufactured by Shin-Etsu Chemical Co., Ltd., Tokyo, Japan and "CAT-RG", a curing catalyst manufactured by the same company, was used.

As silver powder, there were prepared a flaky silver powder, "FA-2-3", manufactured by Dowa Hitech Co., Ltd., Saitama, Japan, and an irregular-shaped silver powder, "G-35" manufactured by the same company. Equal amounts of these were used in each of the samples.

As the dispersant, there were prepared polyether-modified silicone surfactant, "KF-6015" manufactured by Shin-Etsu Chemical Co., Ltd., and polyglycerin-modified silicone surfactant, "KF-6106", manufactured by the same company. Equal amounts of these were used in each of the samples.

For Samples 1 to 9, a paste was produced by adding silver powder, the dispersant, and the mixture of fumed silica powder and silver chloride powder to the binder and mixing them.

For Samples 11 and 12, silver powder, the dispersant, and silver chloride powder were added to the binder, and they were mixed, but since they did not contain fumed silica powder as an aggregation inhibitor for silver chloride powder, silver chloride powder agglomerated and a uniform paste could not be produced (thus, Samples 11 and 12 were not subjected to subsequent steps and to the test. In Fig. 2, the "-" in salt water treatment for Samples 11 and 12 means that neither the salt water treatment nor the conductivity test was conducted due to the paste being inferior). Samples 11 and 12 differed in the amount of silver chloride, but none of them could result in production of a uniform paste. Thus, the effect of fumed silica was confirmed.

For Sample 10, a paste was produced by adding silver powder and the dispersant to the binder and mixing them.

Then, for Samples 1 to 10, as shown in Fig. 1, the paste 2 was coated by screen printing at two locations on a surface of a substrate 1 made of silicone rubber containing PDMS (polydimethylsiloxane). Furthermore, the paste 2 was cured by heating at 150 degrees Celsius for 30 minutes.

For Samples 3 to 7, and 10, except for Samples 1, 2, 8, and 9, after curing the paste 2, the substrate 1 was immersed in a sodium chloride aqueous solution at room temperature for an hour together with the electrodes resulting from the paste 2, and they were then dried.

In each of produced Samples 1 to 9, the silver-silver chloride electrodes 3 had high adhesion to the silicone rubber and did not easily peel off or drop off from the substrate 1. Furthermore, in Sample 10 manufactured for comparison, the silver electrodes 3 had high adhesion to the silicone rubber and did not easily peel off or drop off from the substrate 1. In these samples, the length L of the electrodes 3 was 30 mm, the width W thereof was 5 mm, and the interval IN therebetween was 10 mm.

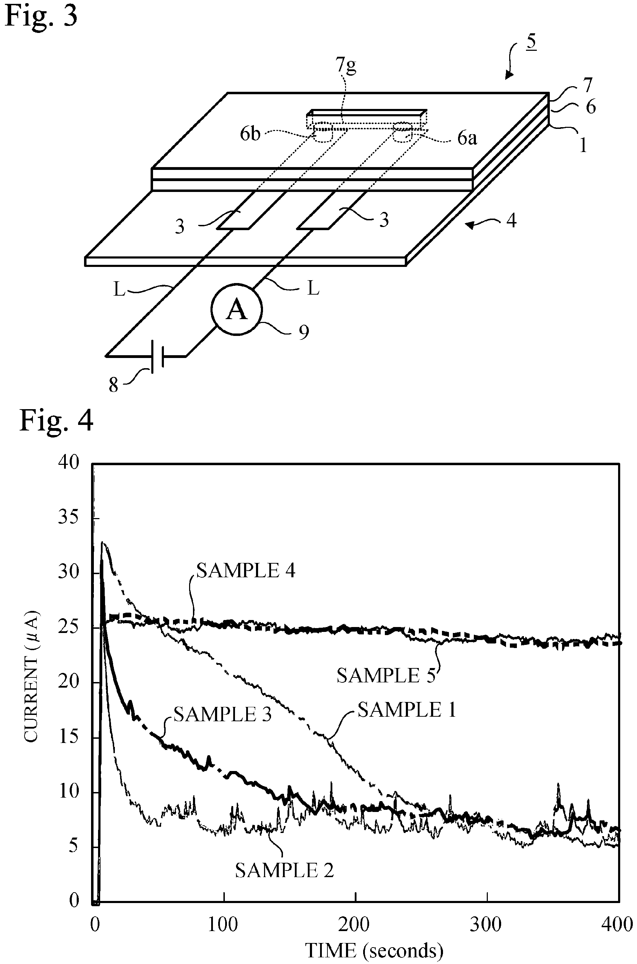

Next, using each of produced Samples 1 to 10, an experimental apparatus 5 shown in Fig. 3 was assembled. The experimental apparatus 5 has plates 4, 6, and 7 that are stacked and bonded to one another. Through-holes 6a and 6b are formed in the plate 6 immediately above the plate 4, and are overlapped with the electrodes 3, respectively. In the uppermost plate 7, a groove 7g that penetrates the plate 7 is formed. One end of the groove 7g is overlapped with the through-hole 6a of the plate 6 directly below, whereas the other end of the groove 7g is overlapped with the through-hole 6b.

Thus, the experimental apparatus 5 is provided with a micro flow channel having the through-holes 6a and 6b and the groove 7g. Both ends of the micro flow channel are closed with the two electrodes 3. Liquid can be stored in the micro flow channel, and liquid can be introduced through the groove 7g. The width of the groove 7g was 1 mm, whereas the diameters of the through-holes 6a and 6b were 2 mm.

PBS (phosphate buffered saline) was supplied to the micro flow channel from the groove 7g. The PBS used was PBS (-) without calcium or magnesium.

A battery 8 (DC power supply) was connected to the electrodes 3 on the surface of the plate 4 via lead wires L, and a voltage of 0.3V was applied so that a DC current flowed through the electrodes 3. Variation of the electric current value was measured by an ammeter 9 for 400 seconds (6 minutes and 40 seconds) immediately after the beginning of electric current supply (voltage application).

Therefore, an electric circuit having two electrodes 3 and PBS (-) therebetween was formed in which the electrodes 3 and PBS (-) were connected in series.

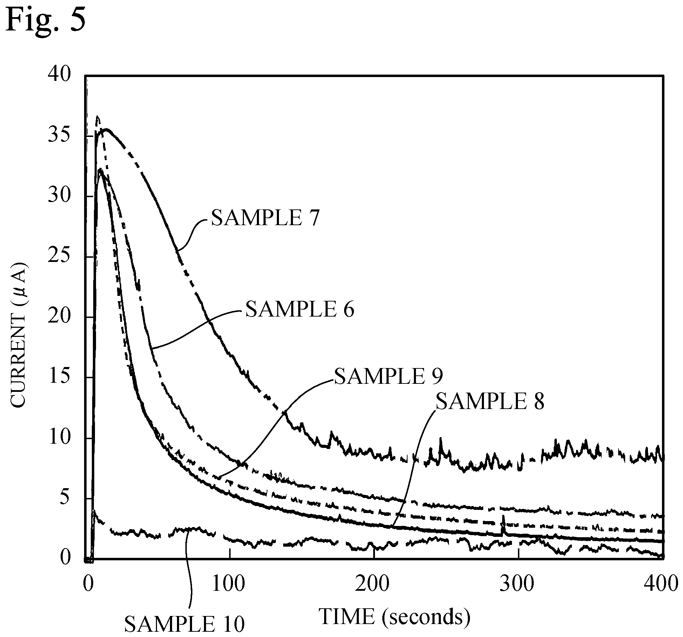

Figs. 4 and 5 show the measurement results. The measurement results in Figs. 4 and 5 are the first measurement results after the plates 4 were manufactured.

As is clear from Figs. 4 and 5, in Samples 4 and 5, the current value was stabilized for 400 seconds after the beginning of voltage application. Samples 4 and 5 contain hydrophilic fumed silica, and the sodium chloride concentration of the solution used in the salt water treatment is high. It is presumed that the silicone rubber contained in the silver-silver chloride electrodes in Samples 4 and 5 contain a large amount of chloride ions and sodium ions derived from sodium chloride, so that the conductivity is improved and the higher conductivity can be stably maintained by the ions.

As is clear from comparison of Samples 4 and 5, even though the silver chloride content was different, the current value was stable for a long time if the sodium chloride concentration of the solution used in the salt water treatment was higher.

In Samples 1 to 3 and 6 to 9, a large current flowed immediately after the beginning of voltage application, but the current value decreased with time.

Sample 1 used the same materials as Sample 4, but was not subjected to the salt water treatment. In sample 1, the current value gradually decreased with time.

Samples 3 and 6 used the same materials as Sample 5, but the sodium chloride concentration of the solution used in the salt water treatment was low for Sample 3, and Sample 6 was not subjected to the salt water treatment. In Samples 3 and 6, the current value gradually decreased and then stabilized.

Sample 7 used the same materials as sample 5, but used hydrophobic fumed silica instead of hydrophilic fumed silica. In Sample 7, a very large current flowed immediately after the beginning of voltage application, but the current value gradually decreased and then stabilized.

Sample 2 used the same materials as Sample 7, but was not subjected to the salt water treatment. In sample 2, the current value decreased rapidly in the initial stage and then stabilized. In Sample 2, the current flowing was smaller than that of Sample 7.

Samples 8 and 9 used the same materials as Sample 5, but the ratio of hydrophilic fumed silica was low and the salt water treatment was not performed. In Samples 8 and 9, the current value gradually decreased and then stabilized.

In Sample 10 having the silver electrodes 3 manufactured for comparison, the current values were lower continuously after the beginning of voltage application than those of Samples 1 to 9 having the silver-silver chloride electrodes 3.

From the above, it is understood that among the samples having the silver-silver chloride electrodes 3, Samples 4 and 5 had good performance.

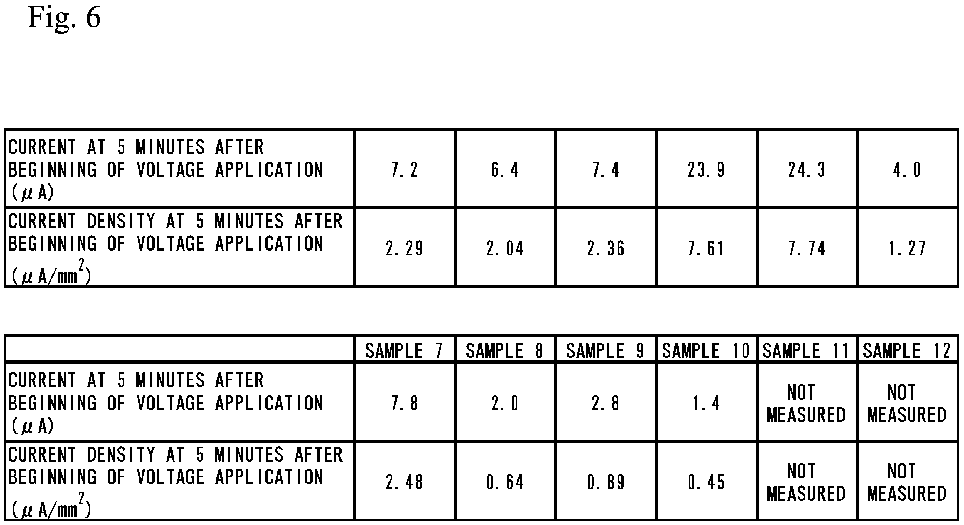

In microfluidic devices, from the viewpoint of shortening the measurement time, it is required that electrodes have high conductivity immediately after the beginning of voltage application. Even Samples 1 to 3 and 6 to 9 having a large decrease in current can also be used utilizing the high conductivity, as long as the measurement is for a short time. Accordingly, Fig. 6 shows the current value for each sample at 300 seconds (5 minutes) after the beginning of voltage application obtained from the measurement results. Moreover, Fig. 6 shows the current density for each sample at 300 seconds (5 minutes) after the beginning of voltage application from a measurement result for universalization. The current density was obtained by dividing the current value by the cross-sectional area of the lead wires L. Since the lead wires L had a diameter of 2 mm, the cross-sectional area thereof was 3.14 mm².

Since Samples 1 to 3 and 6 to 9 can be used in microfluidic devices, it is preferable that the current density of the current flowing through the electric circuit be equal to or greater than 0.64 µA/mm² after 5 minutes from the beginning of voltage application to the electric circuit.

In consideration of the good performance of Samples 4 and 5, it is more preferable that the current density of the current flowing through the electric circuit be equal to or greater than 7.61 µA/mm² after 5 minutes from the beginning of voltage application to the electric circuit.

Although the present invention has been described above, the foregoing description is not intended to limit the present invention. Various modifications including omission, addition, and substitution of structural elements may be made within the scope of the present invention as defined in the claims.

### REFERENCE SYMBOLS

1: Substrate
2: Paste
3: Silver-Silver Chloride Electrode
4: Plate
5: Experimental Apparatus
6: Plate
7: Plate
6a, 6b: Through-hole
7g: Groove

## Claims

1. A silver-silver chloride electrode (3) comprising:
silver powder;
silver chloride powder;
hydrophilic silica powder; and
silicone rubber as a binder in which silver powder, silver chloride powder and hydrophilic silica powder are dispersed,
**characterized in that**
the silver-silver chloride electrode (3) contains a large amount of chloride and sodium ions by being treated by immersion in a 10 wt% sodium chloride aqueous solution such that a current density of a current flowing through an electric circuit is equal to or greater than 7.61 µA/mm² after 5 minutes from the beginning of application of a voltage to the electric circuit when the electric circuit in which two silver-silver chloride electrodes (3) and a phosphate buffered saline (PBS) are connected in series is made up of the two silver-silver chloride electrodes (3) and the phosphate buffered saline containing no calcium and no magnesium interposed between the two silver-silver chloride electrodes (3), wherein the voltage is 0.3 Volts.

2. An electric circuit comprising:
two silver-silver chloride electrodes (3); and
a phosphate buffered saline (PBS) not containing calcium or magnesium interposed between the two silver-silver chloride electrodes (3), the two silver-silver chloride electrodes (3) and the phosphate buffered saline being connected in series,
each silver-silver chloride electrode (3) comprising:
silver powder;
silver chloride powder;
hydrophilic silica powder; and
silicone rubber as a binder in which silver powder, silver chloride powder and hydrophilic silica powder are dispersed,
**characterized in that**
each of the silver-silver chloride electrodes (3) contains a large amount of chloride and sodium ions by being treated by immersion in a 10 wt% sodium chloride aqueous solution such that a current density of a current flowing through the electric circuit is equal to or greater than 7.61 µA/mm² after 5 minutes from the beginning of application of a voltage to the electric circuit, wherein the voltage is 0.3 Volts.

3. The electric circuit according to claim 2, wherein the two silver-silver chloride electrodes (3) are formed on a substrate (1) made of silicone rubber.

## Patentansprüche

1. Silber-Silberchlorid-Elektrode (3), umfassend:
Silberpulver;
Silberchloridpulver;
hydrophiles Siliciumdioxid-Pulver; und
Silikonkautschuk als ein Bindemittel, in dem Silberpulver, Silberchloridpulver und hydrophiles Siliciumdioxidpulver dispergiert sind,
**dadurch gekennzeichnet, dass**
die Silber-Silberchlorid-Elektrode (3) eine große Menge an Chlorid- und Natriumionen dadurch enthält, dass sie durch Eintauchen in eine wässrige 10 Gew.-%ige Natriumchloridlösung so behandelt wird, dass die Stromdichte eines durch einen Stromkreis fließenden Stroms nach 5 Minuten ab dem Beginn des Anlegens einer Spannung an den Stromkreis gleich oder größer als 7,61 µA/mm² ist, wenn der Stromkreis, in dem zwei Silber-Silberchlorid-Elektroden (3) und eine phosphatgepufferte Saline (PBS) in Reihe geschaltet sind, aus den beiden Silber-Silberchlorid-Elektroden (3) und der phosphatgepufferten Saline, die kein Calcium und kein Magnesium enthält und zwischen den beiden Silber-Silberchlorid-Elektroden (3) angeordnet ist, besteht, wobei die Spannung 0,3 Volt ist.

2. Elektrischer Schaltkreis, umfassend:
zwei Silber-Silberchlorid-Elektroden (3); und
eine phosphatgepufferte Saline (PBS), die kein Calcium oder Magnesium enthält und zwischen den beiden Silber-Silberchlorid-Elektroden (3) angeordnet ist, wobei die beiden Silber-Silberchlorid-Elektroden (3) und die phosphatgepufferte Saline in Reihe geschaltet sind,
jede Silber-Silberchlorid-Elektrode (3) umfasst:
Silberpulver;
Silberchloridpulver;
hydrophiles Siliciumdioxidpulver; und
Silikongummi als Bindemittel, in dem Silberpulver, Silberchloridpulver und hydrophiles Siliciumdioxidpulver dispergiert sind,
**dadurch gekennzeichnet, dass**
jede der Silber-Silberchlorid-Elektroden (3) eine große Menge an Chlorid- und Natriumionen dadurch enthält, dass sie durch Eintauchen in eine wässrige 10 Gew.-%ige Natriumchloridlösung so behandelt wird, dass die Stromdichte eines durch einen Stromkreis fließenden Stroms nach 5 Minuten ab dem Beginn des Anlegens einer Spannung an den Stromkreis gleich oder größer als 7,61 µA/mm² ist, wobei die Spannung 0,3 Volt ist.

3. Elektrischer Schaltkreis nach Anspruch 2, wobei die beiden Silber-Silberchlorid-Elektroden (3) auf einem Substrat (1) aus Silikonkautschuk ausgebildet sind.

## Revendications

1. Électrode argent-chlorure d'argent (3) comprenant :
de la poudre d'argent ;
de la poudre de chlorure d'argent ;
de la poudre de silice hydrophile ; et
du caoutchouc de silicone servant de liant dans lequel la poudre d'argent, la poudre de chlorure d'argent et la poudre de silice hydrophile sont dispersées,
**caractérisée en ce que**
l'électrode argent-chlorure d'argent (3) contient une grande quantité d'ions chlorure et sodium en étant traitée par immersion dans une solution aqueuse de chlorure de sodium à 10 % en poids de telle sorte qu'une densité de courant d'un courant circulant à travers un circuit électrique est égale ou supérieure à 7,61 µA/mm² après 5 minutes à compter du début de l'application d'une tension au circuit électrique quand le circuit électrique dans lequel deux électrodes argent-chlorure d'argent (3) et une solution saline tamponnée au phosphate (PBS) sont branchées en série est constitué des deux électrodes argent-chlorure d'argent (3) et de la solution saline tamponnée au phosphate ne contenant ni calcium, ni magnésium intercalée entre les deux électrodes argent-chlorure d'argent (3), la tension étant de 0,3 volt.

2. Circuit électrique comprenant :
deux électrodes argent-chlorure d'argent (3) ; et
une solution saline tamponnée au phosphate (PBS) ne contenant ni calcium, ni magnésium intercalée entre les deux électrodes argent-chlorure d'argent (3), les deux électrodes argent-chlorure d'argent (3) et la solution saline tamponnée au phosphate étant branchées en série,
chaque électrode argent-chlorure d'argent (3) comprenant :
de la poudre d'argent ;
de la poudre de chlorure d'argent ;
de la poudre de silice hydrophile ; et
du caoutchouc de silicone servant de liant dans lequel la poudre d'argent, la poudre de chlorure d'argent et la poudre de silice hydrophile sont dispersées,
**caractérisé en ce que**
chacune des électrodes argent-chlorure d'argent (3) contient une grande quantité d'ions chlorure et sodium en étant traitée par immersion dans une solution aqueuse de chlorure de sodium à 10 % en poids de telle sorte qu'une densité de courant d'un courant circulant à travers le circuit électrique est égale ou supérieure à 7,61 µA/mm² après 5 minutes à compter du début de l'application d'une tension au circuit électrique, la tension étant de 0,3 volt.

3. Circuit électrique selon la revendication 2, dans lequel les deux électrodes argent-chlorure d'argent (3) sont formées sur un substrat (1) constitué de caoutchouc de silicone.
